# EUROPÄISCHE PATENTANMELDUNG

(11) **EP 0 607 838 A2**
(43) Veröffentlichungstag der Anmeldung: **27.07.1994**
(21) Anmeldenummer: 94100283.4
(22) Anmeldetag: 11.01.1994
(51) Int. Cl.: H01C 1/08, H01C 7/00

(54) **Integrierte Leistungswiderstandsanordnung**

(30) Priorität: 21.01.1993 DE 4301552
(71) Anmelder: TEMIC TELEFUNKEN microelectronic GmbH, D-74072 Heilbronn (DE)
(72) Erfinder: Golberg, Hans-Joachim, D-89079 Ulm (DE)

(57) **Zusammenfassung**

Es wird eine integrierte Leistungswiderstandsanordnung vorgeschlagen, die durch vorteilhafte Flächenverteilung der Verlustleistung hoch belastbar und dadurch besonders vorteilhaft in Schutzschaltungen zur Vernichtung energiereicher Störimpulse einsetzbar ist.

## Beschreibung

Die Erfindung betrifft eine integrierte Leistungswiderstandsanordnung
Integrierte elektronische Schaltungen sind im allgemeinen auf möglichst geringe Verlustleistung ausgelegt. Es gibt aber auch Fälle in denen eine Verlustleistung gewollt ist, beispielsweise zur Vernichtung energiereicher Störimpulse in Schutzschaltungen an Eingängen gefährdeter Schaltkreise. Günstig ist es, wenn die zur Umsetzung der Störimpulsenergie in Wärme benötigten Leistungswiderstände evtl. in Verbindung mit weiteren Schaltungselementen ebenfalls in integrierter Bauweise zur Verfügung stehen.

Aufgabe der Erfindung ist es daher, eine vorteilhafte integrierte Leistungswiderstandsanordnug anzugeben.

Erfindungsgemäße Lösungen dieser Aufgabe sind in den Patentansprüchen 1 und 4 beschrieben. Die Unteransprüche enthalten vorteilhafte Ausgestaltungen und Weiterbildungen der Erfindung. Die Lösungen sind einzeln oder vorzugsweise in Kombination einsetzbar.

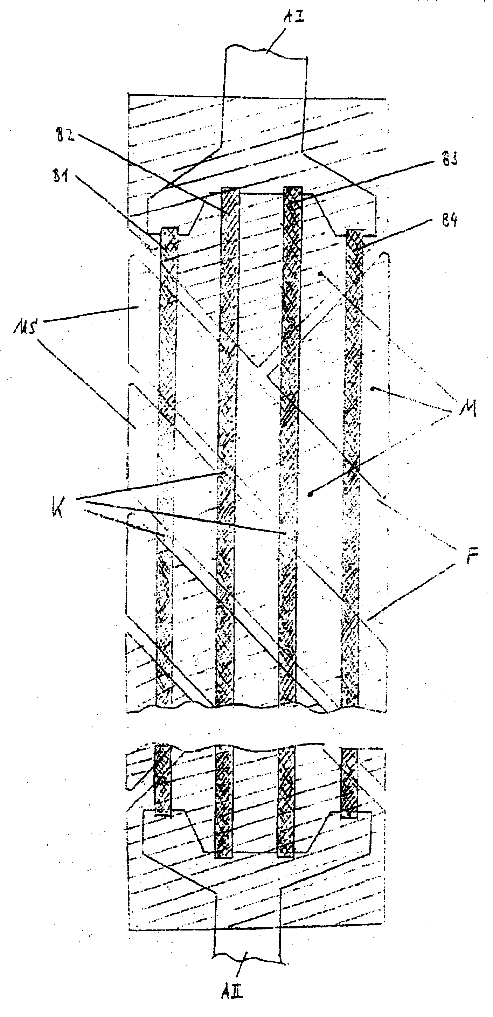

Die Erfindung ist nachfolgend an Ausführungsbeispielen unter Bezugnahme auf die Abbildung noch eingehend erläutert.

In der skizzierten Anordnung ist ein integrierter Leistungswiderstand durch vier parallele Widerstandsbahnen B1, B2, B3, B4, z.B. aus dotiertem Polysilizium oder einem anderen integrierbaren Widerstandsmaterial auf einem isolierenden Substrat realisiert. Die in ihrem Längsverlauf gegeneinander isolierten Widerstandsbahnen sind an den Bahnenden durch Anschlußflächen AI bzw. AII kontaktiert und untereinander und mit anderen Schaltungsteilen verbunden. Der Widerstandswert zwischen AI und AII ergibt sich aus der Parallelschaltung der Teilwiderstände der vier Widerstandsbahnen. Eine zwischen den Anschlußflächen AI, AII anliegende Spannung führt zu Strömen durch alle vier Widerstandsbahnen und infolge der Verlustleistung zu einer Erhitzung der Widerstandsbahnen. Die Verlustwärme wird über Substrat und Deckschicht abgeführt, wobei die Randbedingungen aber für die inneren Bahnen B2, B3 anders sind als für die äußeren Bahnen B1, B4. Die Widerstandsbahnen sind nun so dimensioniert, daß die flächenbezogene Verlustleistung im Bereich der inneren Bahnen geringer ist als im Bereich der äußeren Bahnen. Hierzu sind vorzugsweise die inneren Bahnen B2, B3 wie skizziert länger ausgeführt sein als die äußeren Bahnen B1, B4. Dies führt zu einer Verdrängung der Verlustleistung von den inneren zu den den äußeren Teilwiderständen und damit zu einem Ausgleich der Temperaturbelastung aller Widerstandsbahnen. Eine schmälere Ausführung der inneren gegenüber den äußeren Bahnen oder eine Vergrößerung des gegenseitigen Abstands der inneren Bahnen führt zu einer Verringerung der auf die Substratfläche bezogenen mittleren Flächenleistung.

Die Verteilung der in den Widerstandsbahnen entstehenden Verlustwärme auf eine größere Fläche wird unterstüzt durch eine die Widerstandsbahnen überdeckende Wärmeleitschicht M, die wegen der gewünschten guten Wärmeleiteigenschaften aus Metall, vorzugsweise Aluminium besteht. Die metallische Schicht ist dielektrisch gegen die Widerstandsbahnen isoliert. Die Wärmeleitschicht ist in quer zur Bahnenlängsrichtung liegende Streifen MS unterteilt, die durch Isolationsfugen F voneinander getrennt sind. Hierdurch können zu hohe Potentialdifferenzen zwischen von einer einheitlichen geschlossenen Wärmeleitfläche überdeckten Punkten der Widerstandsbahnen und dadurch u.U. verursachte Durchbrüche durch die Isolierschicht, insbesondere bei starker Erhitzung, vermieden werden.

An den Kreuzungspunkten K von Isolationsfugen F und Widerstandsbahnen steigt wegen fehlender Wärmeleitschicht die Temperatur bei Belastung wesentlich stärker als in den überdeckten Abschnitten der Bahnen. Vorteilhafterweise sind daher die Isolationsfugen schräg gegen die Bahnenlängsrichtung verlaufend ausgeführt, so daß die Kreuzungspunkte einer Isolationsfuge von einer Bahn zur nächsten in Längsrichtung der Bahnen gegeneinander versetzt auftreten und der minimale Abstand benachbarter Kreuzungspunkte gegenüber senkrecht zu den Bahnen verlaufender Isolationsfugen deutlich erhöht ist.

Im skizzierten Beispiel sind die Metallstreifen MS als gerade Streifen ausgeführt, die vorzugsweise alle Widerstandsbahnen überdecken. Die Bemessung von Neigungswinkel und Breite der Streifen können an den Erfordernissen des Einzelfalls ausgerichtet werden.

## Patentansprüche

1. Integrierte Leistungswiderstandsanordnung mit mindestens drei parallelen Widerstandsbahnen, die so dimensioniert sind, daß die flächenbezogene Verblustleistung im Bereich der mittleren Bahn(en) geringer ist als im Bereich der äußeren Bahnen.

2. Anordnung nach Anspruch 1, dadurch gekennzeichnet, daß die Bahnlänge von außen nach innen zunimmt.

3. Anordnung nach Anspruch 1 oder 2 , dadurch gekennzeichnet, daß die Bahnbreite von außen nach innen abnimmt.

4. Integrierte Leistungswiderstandsanordnung mit mehreren parallelen Widerstandsbahnen und einer die Widerstandsbahnen zumindest teilweise überdeckenden und gegen diese isolierten metallischen Wärmeleitschicht (M), die in durch quer zur Bahnenlängsrichtung verlaufende, durch Isolationsfugen (F) getrennte Streifen (MS) unterteilt ist.

5. Anordnung nach Anspruch 4, dadurch gekennzeichnet, daß die Isolationsfugen schräg zur Längsrichtung der Widerstandsbahnen verlaufen in der Art, daß die Kreuzungspunkte (K) einer Isolationsfuge mit unmittelbar benachbarten Widerstandsbahnen in Bahnenlängsrichtung versetzt sind.

6. Anordnung nach A 4 oder 5, dadurch gekennzeichnet, daß die Streifen über alle Widerstandsbahnen verlaufen.

7. Integrierte Leistungswiderstandsanordnung nach einem der Ansprüche 1 bis 3 und einem der Ansprüche 4 bis 6.

8. Anordnung nach einem der Ansprüche 1 bis 7, dadurch gekennzeichnet, daß die Widerstandsbahnen aus polykristallinem Silizium bestehen.
